# EUROPÄISCHE PATENTSCHRIFT

(11) **EP 3 208 837 B1**
(45) Veröffentlichungstag und Bekanntmachung des Hinweises auf die Patenterteilung: **24.11.2021**
(21) Anmeldenummer: 17152192.5
(22) Anmeldetag: 19.01.2017
(51) Int. Cl.: H01L 23/02, H01L 23/043, H01L 23/10, H01L 25/07, H01L 25/11, H02M 1/00, H05K 5/00, H05K 5/02, H05K 5/06, H05K 7/14, H02M 7/00

(54) **ELEKTRISCHES MODUL MIT ELEKTRISCHER KOMPONENTE**
ELECTRIC MODULE WITH ELECTRICAL COMPONENT
MODULE ÉLECTRIQUE COMPRENANT UN COMPOSANT ÉLECTRIQUE

(30) Priorität: 19.02.2016 DE 102016202600
(43) Veröffentlichungstag der Anmeldung: 23.08.2017
(73) Patentinhaber: Siemens Energy Global GmbH & Co. KG, 81739 München (DE)
(72) Erfinder: Kübel, Thomas, 91056 Erlangen (DE); Schmitt, Daniel, 92353 Postbauer-Heng (DE)

(56) Entgegenhaltungen:
- WO-A1-2009/062534
- DE-A1- 3 215 632
- DE-A1- 10 225 333
- DE-A1-102012 211 446
- DE-A1-102014 104 856
- US-A1- 2007 134 951

## Beschreibung

Die Erfindung bezieht sich auf elektrische Module, die jeweils mit mindestens einer in einem Modulgehäuse untergebrachten elektrischen Komponente ausgestattet sind.

Derartige elektrische Module werden beispielsweise bei elektrischen Umrichtern, insbesondere Multilevelumrichtern, eingesetzt, bei denen eine Vielzahl an elektrischen Modulen der beschriebenen Art sehr dicht nebeneinander angeordnet ist.

Die Module sind bei solchen Umrichtern häufig unter Bildung von Modulreihenschaltungen elektrisch in Reihe geschaltet.

Die Druckschrift WO 2012/156261 A2 beschreibt ein Ausführungsbeispiel für einen Multilevelumrichter, bei dem elektrische Module, wie sie hier nachfolgend beschrieben werden, eingesetzt werden können.

Insbesondere im Bereich der Energieübertragungstechnik werden die beschriebenen elektrischen Module mit sehr großen elektrischen Strömen belastet, so dass im Falle eines Ausfalls einer Komponente bzw. in einem Fehlerfall aufgrund der umgesetzten elektrischen Leistung eine explosionsartige Zerstörung der im Modulgehäuse befindlichen elektrischen Komponente bzw. Komponenten erfolgen kann; weicht Explosionsgas (z. B. metallischer/kohlenstoffhaltiger Staub, Splitter etc.) aus dem Modulgehäuse aus, können benachbarte elektrische Module, die zuvor noch elektrisch einwandfrei arbeiteten, von dem Explosionsgas beeinträchtigt oder zerstört werden, da dadurch die Luftstrecke aufgrund der Verunreinigungen unterschritten wird, so dass eine Kettenreaktion auftreten kann, durch die eine Vielzahl an benachbarten elektrischen Modulen zerstört wird. Bei den oben beschriebenen Umrichtern kann dies - insbesondere im Hochspannungsbereich - dramatische Folgen haben. Aus der DE 10 2014 104 856 A1 ist es bekannt, bei einem elektrischen Modul dessen Gehäuserahmen zur zusätzlichen Sicherung mit übrigen Gehäusekomponenten zu verkleben.

Die DE 10 2012 211 446 A1 offenbart eine elektrische Komponente, bei der im Fall einer Verwendung von zwei oder mehr zusammengesetzten Gehäuse-Seitenwandsegmenten, diese miteinander durch Kleben zu einer ringförmigen Seitenwand miteinander verbunden sind.

Die DE 32 15 632 A1 zeigt eine elektrische Komponente mit einem zylindrischen Gehäuse mit zwei Gehäuseringen. Für eine explosionsgeschützte Verbindung der Gehäuseringe ist an deren Trennflächen zusätzlich ein unlösbares Verkleben vorgesehen.

Der Erfindung liegt die Aufgabe zugrunde, ein elektrisches Modul anzugeben, das sich einfach und kostengünstig fertigen lässt und im Falle eines Fehlers bzw. einer Explosion im Innenraum des Modulgehäuses einen Gasfluss nach außen bzw. ein Austreten von Explosionsgasen nach außen verhindert, zumindest aber besser als bisher hemmt.

Diese Aufgabe wird erfindungsgemäß durch ein elektrisches Modul mit den Merkmalen gemäß Patentanspruch 1 gelöst. Vorteilhafte Ausgestaltungen des erfindungsgemäßen Moduls sind in Unteransprüchen angegeben.

Danach ist erfindungsgemäß vorgesehen, dass das Modulgehäuse zumindest zwei Gehäuseteile aufweist, die aufeinander liegen und allein oder gemeinsam mit einem oder mehreren weiteren Gehäuseteilen des Modulgehäuses den Innenraum des Modulgehäuses begrenzen, und zwischen den beiden Gehäuseteilen mindestens eine Klebeschicht vorhanden ist, die die beiden Gehäuseteilen miteinander verklebt.

Ein wesentlicher Vorteil des erfindungsgemäßen Moduls besteht darin, dass durch die erfindungsgemäß vorgesehene Verklebung von Gehäuseteilen des Modulgehäuses eine einfache und kostengünstige Montage und Fertigung des Moduls möglich ist. Dabei kann in überraschender Weise zwischen den verklebten Gehäuseteilen eine so große Haltekraft erreicht werden, dass selbst im Falle einer Explosion im Gehäuseinneren das Modulgehäuse zusammengehalten wird und die eingangs beschriebene Gefährdung benachbarter Module vermieden wird.

Mit Blick auf eine besonders gute Dichtwirkung wird es als vorteilhaft angesehen, wenn die Klebeschicht einen Schichtring bildet, der ringförmig um den Innenraum des Modulgehäuses umläuft.

Zumindest eines der zwei Gehäuseteile weist mindestens eine Vertiefung auf, deren Innenwand mit der Klebeschicht bedeckt ist.

Das andere der zwei Gehäuseteile weist einen Vorsprung auf, der in die Vertiefung eingreift. Die Innenwand der Vertiefung und der Vorsprung sind vorzugsweise durch die Klebeschicht miteinander verklebt.

Erfindungsgemäß weist die Klebeschicht mindestens einen Schichtabschnitt auf, der im Querschnitt u-förmig oder zumindest abschnittsweise u-förmig ist und zwei Seitenwände und eine die beiden Seitenwände verbindende Bodenwand aufweist, jede der beiden Seitenwände jeweils einen Klebeabschnitt bildet, der winklig zur Auflageebene, in der die zwei Gehäuseteile aufeinander liegen, angeordnet ist und die Bodenwand des Schichtabschnitts auf einem, insbesondere parallel zur Auflageebene liegenden, Vertiefungsboden einer Vertiefung in einem der zwei Gehäuseteile, insbesondere auf einem Nutboden im Falle einer nutförmigen Vertiefung, aufliegt.

Mit Blick auf eine ringförmige Abdichtung wird es als vorteilhaft angesehen, wenn die Vertiefung ringförmig ist und ringförmig um den Innenraum des Modulgehäuses außen herumläuft, der in die Vertiefung eingreifende Vorsprung des anderen Gehäuseteils ebenfalls ringförmig um den Innenraum des Modulgehäuses außen herumläuft und als ringförmiger Vorsprung in die ringförmige Vertiefung eingreift und ein zwischen der Innenwand der Vertiefung und dem eingreifenden Vorsprung liegender Schichtabschnitt der Klebeschicht einen ringförmigen Dichtring bildet, der den Innenraum des Modulgehäuses ringförmig abdichtet.

Bezüglich einer Durchführung von elektrischen Kontakten nach außen wird es als vorteilhaft angesehen, wenn die Vertiefung halbringförmig oder wegen nach außen herausgeführter elektrischer Kontakte nur annähernd halbringförmig ist und um die Hälfte des Innenraums des Modulgehäuses oder nahezu die Hälfte außen herumläuft, der in die Vertiefung eingreifende Vorsprung des anderen Gehäuseteils ebenfalls halbringförmig oder wegen durchgeführter elektrischer Kontakte nur annähernd halbringförmig ist und ebenfalls um die Hälfte des Innenraums des Modulgehäuses oder nahezu die Hälfte außen herumläuft, und ein zwischen der Innenwand der Vertiefung und dem eingreifenden Vorsprung liegender Schichtabschnitt der Klebeschicht einen halbringförmigen Dichtring bildet, der den Innenraum des Modulgehäuses halbringförmig oder annähernd halbringförmig abdichtet.

Die Klebeschicht bettet elektrische Kontakte des Moduls, die zwischen den zwei miteinander verklebten Gehäuseteilen nach außen herausgeführt sind, im Bereich zwischen den zwei miteinander verklebten Gehäuseteilen vorzugsweise vollständig ein.

Die erwähnte Vertiefung ist vorzugsweise nutförmig und bildet vorzugsweise also eine Nut, insbesondere eine Nut mit einem quadratischen, rechteckförmigen, dreieckförmigen, vieleckigen oder runden, insbesondere halbkreisförmigen oder halbovalförmigen, Querschnitt.

Mit Blick auf eine zwei- oder mehrstufige radiale Mäandrierung zum Verlangsamen eines austretenden Explosionsgasflusses weisen die zwei Gehäuseteile mindestens zwei ringförmige Verbindungsbereiche auf, die ringförmig um den Innenraum des Modulgehäuses umlaufen und jeweils durch eine Vertiefung in einem der zwei Gehäuseteile und einem formkomplementären Vorsprung in dem jeweils anderen Gehäuseteil gebildet sind, und in den ringförmigen Verbindungsbereichen Vorsprung und Innenwand der Vertiefung jeweils mittels der Klebeschicht verklebt sind.

Erfindungsgemäß bildet einer der zwei ringförmigen Verbindungsbereiche einen innenliegenden ringförmigen Verbindungsbereich, wobei jeder der übrigen ringförmigen Verbindungsbereiche zumindest den inneren ringförmigen Verbindungsbereich radial außen umschließt, wobei die ringförmigen Verbindungsbereiche von innen radial nach außen betrachtet eine zwei- oder mehrstufige, verklebte Mäanderstruktur bilden.

Bezüglich der abzudichtenden Gehäuseteile wird es als vorteilhaft angesehen, wenn eines der zwei Gehäuseteile eine die elektrische Komponente tragende Kühlplatte bildet und das andere der zwei Gehäuseteile ein ringförmiges Rahmenelement ist. Alternativ können beide Gehäuseteile jeweils ringförmige Rahmenelemente bilden. Die Kühlplatten bestehen vorzugsweise aus einem leitenden Material, beispielsweise Metall; die ringförmigen Rahmenelemente bestehen vorzugsweise aus einem nicht- oder schlechtleitenden Material und bilden vorzugsweise einen Isolator.

Mit Blick auf einen Einsatz bei Umrichtern, insbesondere Umrichtern für Hochspannungsanlagen, wird es als vorteilhaft angesehen, wenn das Modulgehäuse folgende Modulgehäuseteile umfasst:
- eine untere Kühlplatte, die eine untere elektrische Komponente, vorzugsweise ein Halbleiterschaltelement, insbesondere ein einen Transistor aufweisendes Halbleiterschaltelement, trägt,
- ein unteres ringförmiges Rahmenelement, das auf der unteren Kühlplatte aufliegt,
- ein mittleres ringförmiges Rahmenelement, das auf dem unteren Rahmenelement aufliegt, wobei zwischen dem unteren und dem mittleren ringförmigen Rahmenelement zumindest zwei Kontaktschienen zur Kontaktierung der unteren elektrischen Komponente aus dem Modulgehäuse herausgeführt sind, insbesondere an einander gegenüberliegenden Stellen herausgeführt sind,
- ein oberes ringförmiges Rahmenelement, das auf dem mittleren ringförmigen Rahmenelement aufliegt, wobei zwischen dem mittleren und dem oberen ringförmigen Rahmenelement zumindest zwei Kontaktschienen zur Kontaktierung einer oberen elektrischen Komponente, vorzugsweise eines Halbleiterschaltelements, insbesondere eines einen Transistor aufweisenden Halbleiterschaltelements, aus dem Modulgehäuse herausgeführt sind, insbesondere an einander gegenüberliegenden Stellen herausgeführt sind, und
- eine obere Kühlplatte, die auf dem oberen ringförmigen Rahmenelement aufliegt und die oberen elektrische Komponente trägt.

Die oben beschriebenen und mittels der mindestens einen Klebeschicht verklebten und durch die Klebeschicht abgedichteten Gehäuseteile bilden vorzugsweise zwei der genannten Modulgehäuseteile, die unmittelbar aufeinander liegen. Besonders bevorzugt sind alle der genannten Gehäuseteile miteinander verklebt.

Die Gehäuseteile bzw. die Modulgehäuseteile können zusätzlich auf andere Weise miteinander verbunden sein, beispielsweise verschraubt, oder zusätzlich durch eine externe Spannvorrichtung zusammengehalten, insbesondere aufeinander gedrückt, werden.

Das Modul bildet vorzugsweise ein Umrichtermodul für den Einsatz in der Energieübertragungstechnik.

Die Erfindung bezieht sich außerdem auf einen Umrichter, insbesondere für den Einsatz in der Energieübertragungstechnik und insbesondere für Multilevelumrichter, mit einer Vielzahl an elektrischen Modulen.

Bezüglich eines solchen Umrichters ist vorgesehen, dass zumindest eines der Module, vorzugsweise alle Module, Module wie oben beschrieben sind. Bezüglich der Vorteile des Umrichters sei auf die obigen Ausführungen verwiesen.

Die Erfindung wird nachfolgend anhand von Ausführungsbeispielen näher erläutert; dabei zeigen beispielhaft
- Figur 1: zur allgemeinen Erläuterung ein Beispiel für ein elektrisches Modul ohne Dichtelemente, das nicht unter den Schutzumfang der Erfindung fällt,
- Figur 2: einen Ausschnitt des Moduls gemäß Figur 1 in einer vergrößerten Darstellung im Falle einer Explosion im Innenraum des Modulgehäuses,
- Fig. 3-4: ein Beispiel für ein elektrisches Modul mit planen Klebeschichten, das nicht unter den Schutzumfang der Erfindung fällt,
- Fig. 5-9: ein Beispiel für ein elektrisches Modul mit nichtplanen Klebeschichten und einer einstufigen Mäanderstruktur, das nicht unter den Schutzumfang der Erfindung fällt und
- Fig. 10-11: ein Ausführungsbeispiel für ein elektrisches Modul mit nichtplanen Klebeschichten und einer mehrstufigen Mäanderstruktur gemäß der vorliegenden Erfindung.

In den Figuren werden der Übersicht halber für identische oder vergleichbare Komponenten stets dieselben Bezugszeichen verwendet.

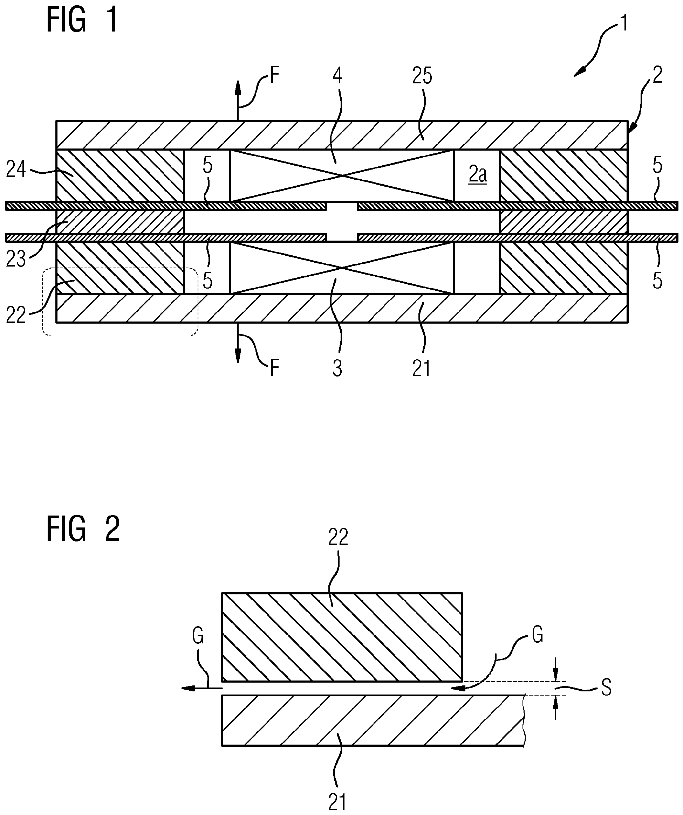

Die Figur 1 zeigt ein elektrisches Modul 1, das ein nach außen verschlossenes Modulgehäuse 2 umfasst. Innerhalb des Modulgehäuses 2 befinden sich ein in der Figur 1 unteres Halbleiterschaltelement 3 und ein in der Figur 1 oberes Halbleiterschaltelement 4. Bei den Halbleiterschaltelementen 3 und 4 handelt es sich beispielsweise um Bipolartransistoren mit isolierter Gateelektrode. Zur Kontaktierung der beiden Halbleiterschaltelemente 3 und 4 sind Kontaktschienen 5 vorhanden, die seitlich aus dem Modulgehäuse 2 herausgeführt sind.

Das Modulgehäuse 2 umfasst zur Kühlung des unteren Halbleiterschaltelements 3 eine in der Figur 1 untere Kühlplatte 21, auf der ein in der Figur 1 unteres ringförmiges Rahmenelement 22 aufliegt. Auf dem unteren ringförmigen Rahmenelement 22 befindet sich ein mittleres ringförmiges Rahmenelement 23, auf dem wiederum ein in der Figur 1 oberes ringförmiges Rahmenelement 24 aufliegt. Nach oben hin wird das Modulgehäuse 2 von einer oberen Kühlplatte 25 abgeschlossen, die auf dem oberen ringförmigen Rahmenelement 24 aufliegt und zur Kühlung des Halbleiterschaltelements 4 dient. Die Kontaktschienen 5 sind zwischen dem mittleren ringförmigen Rahmenelement 23 und dem unteren ringförmigen Rahmenelement 22 bzw. zwischen dem mittleren ringförmigen Rahmenelement 23 und dem oberen ringförmigen Rahmenelement 24 seitlich herausgeführt.

Zum Zusammenhalten der durch die Gehäuseteile des Modulgehäuses 2 gebildeten Sandwichstruktur dienen vorzugsweise Schrauben oder eine externe Spannvorrichtung, die aus Gründen der Übersicht in der Figur 1 nicht weiter gezeigt sind. Beispielsweise können auch mehrere elektrische Module 1 mit ihren Kühlplatten (elektrisch isoliert voneinander) aufeinander liegen; im Falle eines solchen Beispiels hält die Spannvorrichtung vorzugsweise den Stapel aus Sandwichstrukturen zusammen.

Im Falle eines elektrischen Fehlers und im Falle einer Explosion im Innenraum 2a des Modulgehäuses 2 kann ein sehr hoher Gasdruck entstehen, durch den die Modulgehäuseteile nach außen gedrückt werden; die Kraftwirkung durch den Innendruck im Innenraum 2a ist in der Figur 1 durch Pfeile mit dem Bezugszeichen F gekennzeichnet.

Die Figur 2 zeigt den in der Figur 1 mit gestrichelten Linien markierten Abschnitt des Modulgehäuses 2 in einer vergrößerten Darstellung näher im Detail, wenn im Falle einer Explosion im Innenraum 2a des Modulgehäuses 2 die untere Kühlplatte 21 von dem unteren ringförmigen Rahmenelement 22 - trotz der dagegen wirkenden Haltekraft der Schrauben oder Spannvorrichtung - weggedrückt wird. Es lässt sich erkennen, dass zwischen den zwei Modulgehäuseteilen 21 und 22 ein Spalt S entsteht, durch den ein Gasstrom G aus dem Innenraum 2a entweichen kann. Ein solches Entweichen von heißem Gas nach außen ist unerwünscht, da dieses andere elektrische Module, die in unmittelbarer Nachbarschaft angeordnet sind, ebenfalls zerstören bzw. in Mitleidenschaft ziehen könnte.

Um das Problem eines unerwünschten Gasstromes G nach außen im Falle einer Explosion im Innenraum 2a zu vermeiden, sind bei den nachfolgend beschriebenen Beispielen Klebeschichten vorhanden, die die miteinander verklebten Gehäuseteile zusammenhalten und eine Abdichtung des Innenraums 2a des Modulgehäuses 2 ermöglichen. Die Klebschichten können zusätzlich zu den bereits erwähnten Schrauben oder der bereits erwähnten externen Spannvorrichtung eingesetzt werden oder alternativ zu diesen.

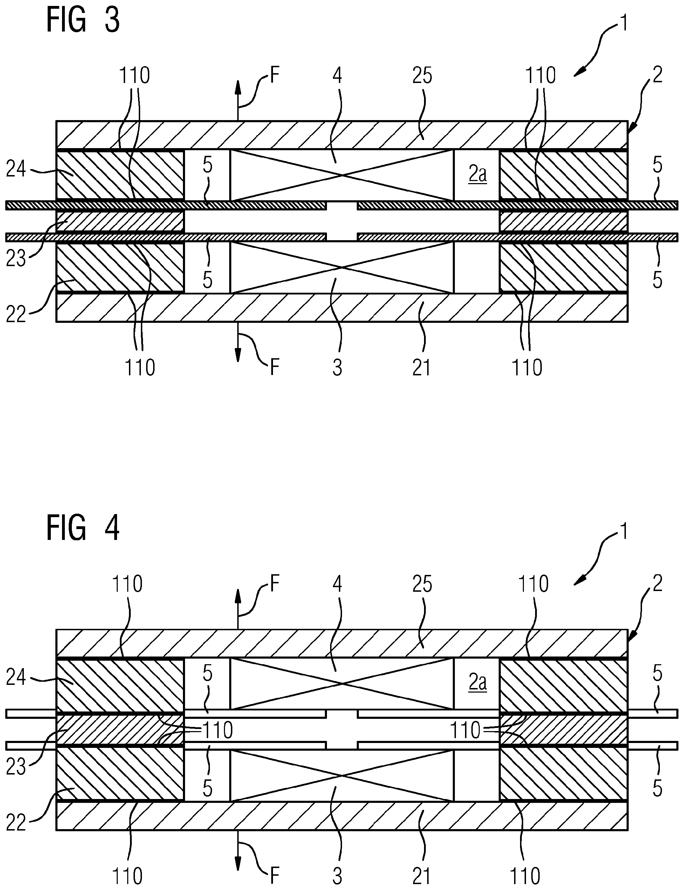

Die Figur 3 zeigt ein Beispiel für ein elektrisches Modul 1, das - im Wesentlichen - dem Aufbau des elektrischen Moduls 1 gemäß Figur 1 entspricht. So weist auch das elektrische Modul 1 gemäß Figur 3 eine untere Kühlplatte 21, drei ringförmige Rahmenelemente 22, 23 und 24 sowie eine obere Kühlplatte 25 auf, die das Modulgehäuse 2 nach außen hin abschließen und einen Innenraum 2a definieren, in dem zwei Halbleiterschaltelemente 3 und 4 untergebracht sind.

Um das im Zusammenhang mit der Figur 2 beschriebene Problem eines unerwünschten Gasstromes G durch einen Spalt S zwischen dem unteren ringförmigen Rahmenelement 22 und der unteren Kühlplatte 21 im Falle einer Explosion zu vermeiden, sind bei dem elektrischen Modul 1 gemäß Figur 3 plane Klebeschichten 110 vorgesehen, die ringförmig um den Innenraum 2a des Modulgehäuses 2 umlaufen.

Die Figur 4 zeigt das elektrische Modul 1 bzw. dessen Modulgehäuse 2 gemäß Figur 3 in einem anderen Querschnitt, nämlich in einem Querschnitt außerhalb des Bereichs der Kontaktschienen 5. Es lässt sich erkennen, dass außerhalb des Bereichs der Kontaktschienen 5 die drei ringförmigen Rahmenelemente 22, 23 und 24 unmittelbar aufeinanderliegen und durch Klebeschichten 110 miteinander verklebt sind.

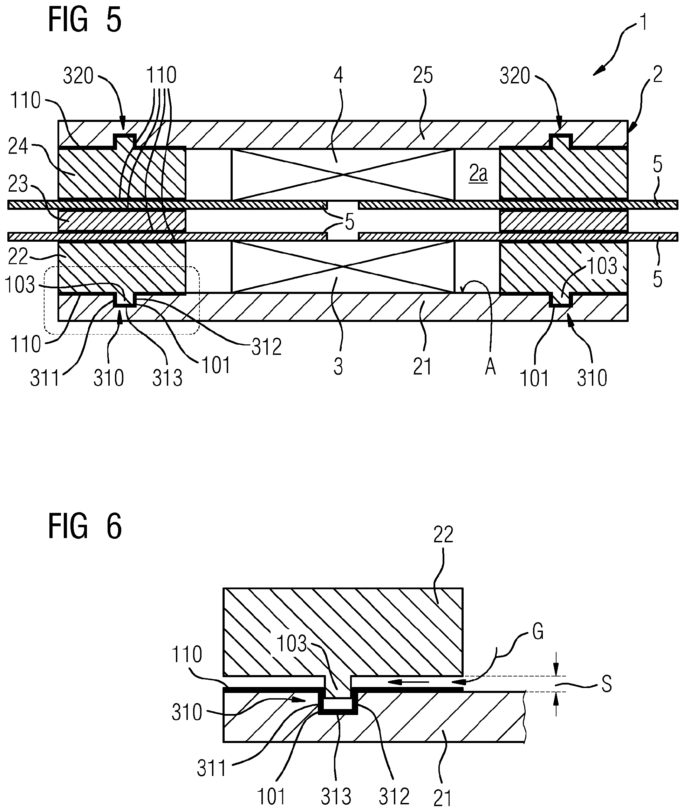

Die Figur 5 zeigt ein weiteres Beispiel für ein elektrisches Modul 1, bei dem zur Abdichtung von Modulgehäuseteilen Klebeschichten 110 vorhanden sind.

Zur Verklebung und zur Abdichtung der in der Figur 5 unteren Kühlplatte 21 und dem darüber liegenden unteren ringförmigen Rahmenelement 22 weist die Klebeschicht 110 bei dem Beispiel gemäß Figur 5 einen Schichtabschnitt 310 auf, der im Querschnitt u-förmig ist und ringförmig um den Innenraum 2a des Modulgehäuses 2 umläuft. Der Schichtabschnitt 310 umfasst zwei Seitenwände 311 und 312, die durch eine Bodenwand 313 verbunden sind. Jede der beiden Seitenwände 311 und 312 steht winklig zur Auflagefläche A bzw. zur Auflageebene, in der die beiden Gehäuseteile 21 und 22 aufeinanderliegen. Die Bodenwand 313 des Schichtabschnitts 310 liegt vorzugsweise parallel zur Auflageebene bzw. Auflagefläche A.

Der im Querschnitt u-förmige Schichtabschnitt 310 liegt in einer ringförmig umlaufenden Vertiefung 101 der unteren Kühlplatte 21. In die durch die beiden Seitenwände 311 und 312 des Schichtabschnitts 310 definierte Innennut greift ein Vorsprung 103 des unteren ringförmigen Rahmenelements 22 ein; der Vorsprung 103 erstreckt sich winklig bzw. senkrecht zur Auflageebene A bzw. zur Auflagefläche zwischen den beiden Gehäuseteilen 21 und 22.

Durch das Eingreifen des Vorsprungs 103 in den u-förmigen Schichtabschnitt 310 wird eine Art Mäandrierung bzw. Mäanderbildung im Bereich der Schnittstelle bzw. Auflagefläche zwischen den Gehäuseteilen 21 und 22 erreicht, durch die im Falle eines Aufreißens der Klebeverbindung und einer Spaltbildung zwischen den Gehäuseteilen nach einer Explosion ein Gasstrom G mehrfach umgelenkt werden muss, bevor er nach außen gelangen kann; dies zeigt die Figur 6 näher im Detail. Es lässt sich erkennen, dass im Falle einer Bildung eines Spalts S ein Gasstrom G nicht parallel zur Auflagefläche A bzw. parallel zur Auflageebene nach außen gelangen kann, sondern zunächst durch den Vorsprung 103 und die nutförmige Vertiefung 101 insgesamt viermal umgelenkt wird, bevor er nach außen gelangen kann. Es erfolgt also eine Verlängerung des Gasweges und damit einhergehend eine signifikante Druck- und Temperaturreduktion des womöglich trotz des Schichtabschnitts 310 dennoch austretenden Restgasstromes.

Darüber hinaus lässt sich in der Figur 6 erkennen, dass der Gasstrom G außerdem durch den u-förmige Schichtabschnitt 310 gestoppt oder zumindest abgebremst wird, der zwischen Vertiefung 101 und Vorsprung 103 verbleibt, selbst wenn die Klebeverbindung als solche durch den Gasdruck zerstört worden ist.

Die Figur 5 zeigt darüber hinaus einen weiteren u-förmigen Schichtabschnitt 320, der das obere ringförmige Rahmenelement 24 und die obere Kühlplatte 25 verklebt und diese beiden Gehäuseteile in derselben Weise abdichtet, wie dies im Zusammenhang mit dem Schichtabschnitt 310 erläutert worden ist.

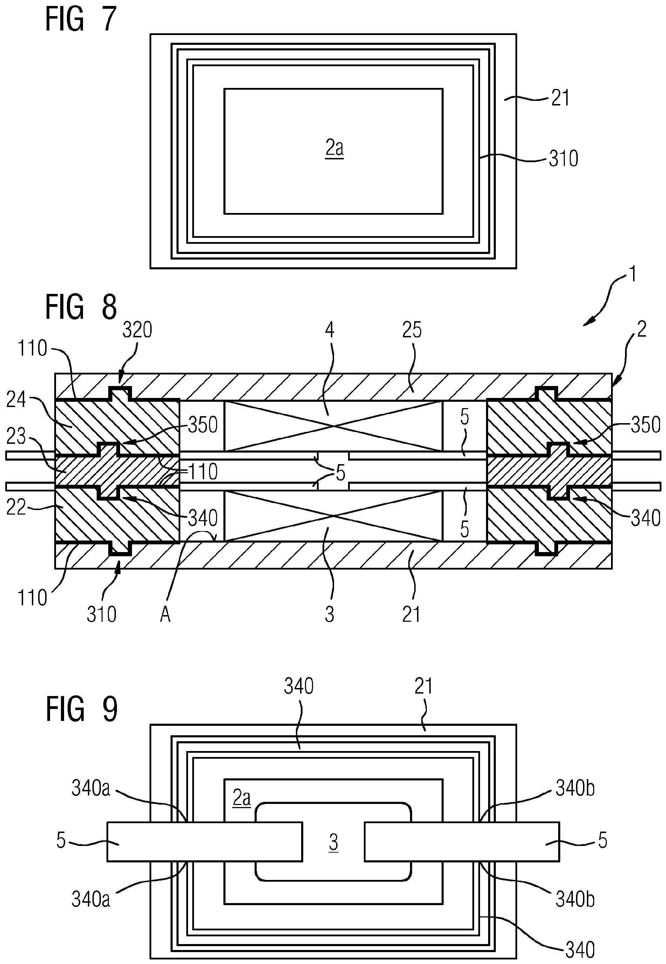

Die Figur 7 zeigt den Schichtabschnitt 310 gemäß Figur 5 in einer Draufsicht. Es lässt sich erkennen, dass der Schichtabschnitt 310 ringförmig um den Innenraum 2a umläuft.

Die Figur 8 zeigt das elektrische Modul 1 gemäß den Figuren 5 bis 7 in einem anderen Querschnitt, und zwar in einem Bereich außerhalb der Kontaktschienen 5. Es lässt sich erkennen, dass im Bereich außerhalb der Kontaktschienen 5 zusätzlich eine Abdichtung der unmittelbar aufeinanderliegenden ringförmigen Rahmenelemente 22 und 23 durch einen halbringförmigen, im Querschnitt u-förmigen Schichtabschnitt 340 der Klebeschicht 110 erfolgt. Der Schichtabschnitt 340 der Klebeschicht 110 verklebt eine Vertiefung im unteren ringförmigen Rahmenelement 22 mit einem korrespondierenden Vorsprung des darüber befindlichen ringförmigen Rahmenelements 23.

Die zur Abdichtung der beiden Rahmenelemente 22 und 23 vorgesehenen halbringförmigen Schichtabschnitte 340 sind in der Figur 9 näher in einer Draufsicht gezeigt. Es lässt sich erkennen, dass die Abschnittsenden 340a und 340b der Schichtabschnitte 340 jeweils paarweise gegenüberliegen und durch die Kontaktschienen 5 voneinander getrennt sind, mit denen die Kontaktierung des unteren Halbleiterschaltelements 3 erfolgt.

In der Figur 8 lässt sich darüber hinaus ein weiterer halbringförmiger Schichtabschnitt 350 erkennen, der im Querschnitt u-förmig ist und zum Verkleben und zur Abdichtung des mittleren ringförmigen Rahmenelements 23 und des darüber befindlichen oberen ringförmigen Rahmenelements 24 geeignet ist. Die Schichtabschnitte 350 können mit den Schichtabschnitten 340 identisch sein, so dass diesbezüglich auf die obigen Beispiele verwiesen sei.

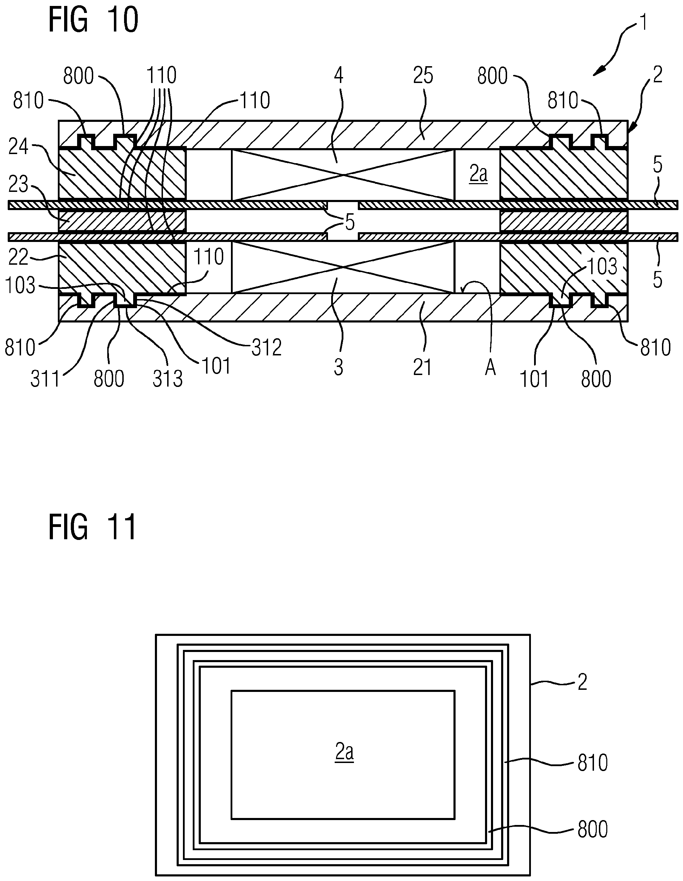

Die Figur 10 zeigt ein Ausführungsbeispiel für ein elektrisches Modul 1, bei dem miteinander verbundene Gehäuseteile jeweils zwei oder mehr ringförmige Verbindungsbereiche aufweisen, die jeweils ringförmig oder halbringförmig um den Innenraum 2a des Modulgehäuses 2 umlaufen und jeweils durch eine Vertiefung in einem Gehäuseteil und einen Vorsprung in dem jeweils anderen Gehäuseteil gebildet sind. In den ringförmigen Verbindungsbereichen sind der Vorsprung und die Innenwand der Vertiefung jeweils verklebt.

In der Figur 10 sind aus Gründen der Übersicht pro Gehäuseteilschnittstelle lediglich zwei ringförmige bzw. halbringförmige Verbindungsbereiche gezeigt und dort mit den Bezugszeichen 800 und 810 gekennzeichnet, jede der Gehäuseteilschnittstellen kann aber - wie erwähnt - auch mehr als zwei ringförmige bzw. halbringförmige Verbindungsbereiche aufweisen.

Die ringförmigen Verbindungsbereichen 800 und 810 sind bevorzugt koaxial bzw. in der Draufsicht gesehen konzentrisch angeordnet. Jeder der ringförmigen Verbindungsbereiche - mit Ausnahme des äußersten Verbindungsbereichs 810 - bildet dabei also jeweils einen innenliegenden ringförmigen Verbindungsbereich für den jeweils nächst äußeren Verbindungsbereich. Die Figur 11 zeigt dies in einer Draufsicht.

Durch die Anordnung der Verbindungsbereiche 800 und 810 bilden diese von innen radial nach außen betrachtet eine mehrfache bzw. mehrstufige Mäanderstruktur für einen nach außen fließenden Gasstrom (vgl. Figur 6, die eine einfache bzw. einstufige Mäanderstruktur zeigt).

Wie im Zusammenhang mit den Beispielen gemäß den Figuren 3 bis 9 und dem Ausführungsbeispiel gemäß Figur 10 erläutert wurde, können zur Verklebung und Abdichtung der beiden Kühlplatten 21 und 25 mit den daran anliegenden ringförmigen Rahmenelementen 22 bzw. 24 also plane Klebeschichten 110 wie in den Figuren 3 und 4 gezeigt, vorgesehen werden, was nicht unter den Schutzumfang der vorliegenden Erfindung fällt, und/oder nicht-plane Klebeschichten mit im Querschnitt u-förmigen Schichtabschnitten 310 bzw. 320 wie in den Figuren 5 bis 10 gezeigt, vorgesehen werden, was im Fall der Abbildung 10 unter den Schutzumfang der vorliegenden Erfindung fällt. Zusätzlich zu den Klebeverbindungen können zum Zusammenhalten der Gehäuseteile des elektrischen Moduls 1 auch noch mechanische Elemente wie Schraubelemente (z. B. Schrauben, Bolzen mit Gewinde, usw.) oder andere Spannelemente eingesetzt werden.

Die im Zusammenhang mit den Figuren 1 bis 9 erläuterten Beispiele und das im Zusammenhang mit den Figuren 10 und 11 erläuterte Ausführungsbeispiel können je nach konkreter Ausgestaltung einen, mehrere oder alle der folgender Vorteile aufweisen:
- Die Klebeschichten gewährleisten eine großflächige und gleichmäßige Kraftaufnahme und verhindern ein Durchbiegen von Gehäuseteilen im Falle einer Explosion.
- Kabel- oder Kontaktdurchführungen können im Rahmen des Aufbringens der Klebeschichten durch zusätzlichen Klebstoff aufwandsarm mit abgedichtet werden.
- Der Fertigungsprozess wird im Vergleich zu herkömmlichen Fertigungsmethoden vereinfacht.

Obwohl die Erfindung im Detail durch ein bevorzugtes Ausführungsbeispiel näher illustriert und beschrieben wurde, so können andere Variationen vom Fachmann hieraus abgeleitet werden.

### Bezugszeichenliste

- 1: Modul
- 2: Modulgehäuse
- 2a: Innenraum
- 3: unteres Halbleiterschaltelement
- 4: oberes Halbleiterschaltelement
- 5: Kontaktschienen
- 21: untere Kühlplatte
- 22: unteres ringförmiges Rahmenelement
- 23: mittleres ringförmiges Rahmenelement
- 24: oberes ringförmiges Rahmenelement
- 25: obere Kühlplatte
- 101: Vertiefung
- 103: Vorsprung
- 110: Klebeschicht
- 310: u-förmiger Schichtabschnitt
- 311: Seitenwand
- 312: Seitenwand
- 313: Bodenwand
- 320: u-förmiger Schichtabschnitt
- 340: u-förmiger Schichtabschnitt
- 350: u-förmiger Schichtabschnitt
- 340a: Schichtabschnittsende
- 340b: Schichtabschnittsende
- 800: Verbindungsbereich
- 810: Verbindungsbereich

- A: Auflagefläche/Auflageebene
- F: Pfeile
- G: Gasstrom
- P: Gasdruck
- S: Spalt

## Patentansprüche

1. Elektrisches Modul (1) mit zumindest einer in einem Modulgehäuse (2) untergebrachten elektrischen Komponente, wobei
- das Modulgehäuse (2) zumindest zwei Gehäuseteile aufweist, die aufeinander liegen und allein oder gemeinsam mit einem oder mehreren weiteren Gehäuseteilen des Modulgehäuses (2) den Innenraum (2a) des Modulgehäuses (2) begrenzen, und
- zwischen den beiden Gehäuseteilen mindestens eine Klebeschicht (110) vorhanden ist, die die beiden Gehäuseteile miteinander verklebt,
- die zwei Gehäuseteile mindestens zwei ringförmige Verbindungsbereiche aufweisen, die ringförmig um den Innenraum (2a) des Modulgehäuses (2) herumlaufen und jeweils durch eine Vertiefung (101) in einem der zwei Gehäuseteile und einem formkomplementären Vorsprung (103) in dem jeweils anderen Gehäuseteil gebildet sind, und
- in den ringförmigen Verbindungsbereichen Vorsprung (103) und Innenwand der Vertiefung (101) jeweils mittels der Klebeschicht (110) verklebt sind, wobei
- einer der ringförmigen Verbindungsbereiche einen innenliegenden ringförmigen Verbindungsbereich bildet und
- jeder der übrigen ringförmigen Verbindungsbereiche zumindest den inneren ringförmigen Verbindungsbereich radial außen umschließt,
- wobei die ringförmigen Verbindungsbereiche von innen radial nach außen betrachtet eine zwei- oder mehrstufige, verklebte Mäanderstruktur bilden, **dadurch gekennzeichnet, dass**
- die Klebeschicht (110) mindestens einen Schichtabschnitt (310) aufweist, der im Querschnitt u-förmig oder zumindest abschnittsweise u-förmig ist und zwei Seitenwände (311, 312) und eine die beiden Seitenwände (311, 312) verbindende Bodenwand (313) aufweist,
- jede der beiden Seitenwände (311, 312) jeweils einen Klebeabschnitt bildet, der winklig zur Auflageebene, in der die zwei Gehäuseteile aufeinander liegen, angeordnet ist und
- die Bodenwand (313) des Schichtabschnitts (310) auf einem, insbesondere parallel zur Auflageebene liegenden, Vertiefungsboden einer Vertiefung (101) in einem der zwei Gehäuseteile, insbesondere auf einem Nutboden im Falle einer nutförmigen Vertiefung (101), aufliegt.

2. Modul (1) nach Anspruch 1,
**dadurch gekennzeichnet, dass**
- die Vertiefung (101) ringförmig ist und ringförmig um den Innenraum (2a) des Modulgehäuses (2) außen herumläuft,
- der in die Vertiefung (101) eingreifende Vorsprung (103) des anderen Gehäuseteils ebenfalls ringförmig um den Innenraum (2a) des Modulgehäuses (2) außen herumläuft und als ringförmiger Vorsprung (103) in die ringförmige Vertiefung (101) eingreift und
- ein zwischen der Innenwand der Vertiefung (101) und dem eingreifenden Vorsprung (103) liegender Schichtabschnitt (310) der Klebeschicht (110) einen ringförmigen Dichtring bildet, der den Innenraum (2a) des Modulgehäuses (2) ringförmig abdichtet.

3. Modul (1) nach einem der voranstehenden Ansprüche,
**dadurch gekennzeichnet, dass** die Klebeschicht (110) elektrische Kontakte des Moduls (1), die zwischen den zwei miteinander verklebten Gehäuseteilen nach außen herausgeführt sind, im Bereich zwischen den zwei miteinander verklebten Gehäuseteilen vollständig einbettet.

4. Modul (1) nach einem der voranstehenden Ansprüche,
**dadurch gekennzeichnet, dass** die Vertiefung (101) nutförmig ist und eine Nut bildet.

5. Modul (1) nach einem der voranstehenden Ansprüche,
**dadurch gekennzeichnet, dass**
- eines der zwei Gehäuseteile eine die elektrische Komponente tragende Kühlplatte (21, 25) bildet und das andere der zwei Gehäuseteile ein ringförmiges Rahmenelement (22, 24) ist oder beide Gehäuseteile jeweils ringförmige Rahmenelemente (22, 23, 24) sind.

6. Modul (1) nach einem der voranstehenden Ansprüche,
**dadurch gekennzeichnet, dass** das Modulgehäuse (2) folgende Modulgehäuseteile umfasst:
- eine untere Kühlplatte (21), die eine untere elektrische Komponente, vorzugsweise ein Halbleiterschaltelement, insbesondere ein einen Transistor aufweisendes Halbleiterschaltelement, trägt,
- ein unteres ringförmiges Rahmenelement (22), das auf der unteren Kühlplatte (21) aufliegt,
- ein mittleres ringförmiges Rahmenelement (23) , das auf dem unteren Rahmenelement (22) aufliegt, wobei zwischen dem unteren und dem mittleren ringförmigen Rahmenelement zumindest zwei Kontaktschienen (5) zur Kontaktierung der unteren elektrischen Komponente aus dem Modulgehäuse (2) herausgeführt sind,
- ein oberes ringförmiges Rahmenelement (24), das auf dem mittleren ringförmigen Rahmenelement (23) aufliegt, wobei zwischen dem mittleren und dem oberen ringförmigen Rahmenelement zumindest zwei Kontaktschienen (5) zur Kontaktierung einer oberen elektrischen Komponente, vorzugsweise eines Halbleiterschaltelements, insbesondere eines einen Transistor aufweisenden Halbleiterschaltelements, aus dem Modulgehäuse (2) herausgeführt sind, und
- eine obere Kühlplatte (25), die auf dem oberen ringförmigen Rahmenelement (24) aufliegt und die obere elektrische Komponente trägt,
wobei die beiden in den Ansprüchen 1 bis 5 genannten, mittels der mindestens einen Klebeschicht (110) verklebten und durch die Klebeschicht (110) abgedichteten Gehäuseteile zwei der genannten Modulgehäuseteile bilden, die unmittelbar aufeinander liegen.

7. Modul (1) nach einem der voranstehenden Ansprüche,
**dadurch gekennzeichnet, dass** das Modul (1) ein Umrichtermodul für den Einsatz in der Energieübertragungstechnik ist.

8. Umrichter, insbesondere Multilevelumrichter, mit einer Vielzahl an elektrischen Modulen,
**dadurch gekennzeichnet, dass** zumindest eines der Module, vorzugsweise alle Module, Module nach einem der voranstehenden Ansprüche 1-7 sind.

## Claims

1. Electrical module (1) comprising at least one electrical component which is accommodated in a module housing (2), wherein
- the module housing (2) has at least two housing parts which lie one on the other and, on their own or together with one or more further housing parts of the module housing (2), delimit the interior (2a) of the module housing (2), and
- there is at least one adhesive layer (110) between the two housing parts, said adhesive layer adhesively bonding the two housing parts to one another,
- the two housing parts have at least two annular connecting regions which run around the interior (2a) of the module housing (2) in an annular manner and are each formed by a recess (101) in one of the two housing parts and a protrusion (103) of complementary shape in the respectively other housing part, and
- the protrusion (103) and the inner wall of the recess (101) are each adhesively bonded by means of the adhesive layer (110) in the annular connecting regions, wherein
- one of the annular connecting regions forms an internal annular connecting region and
- each of the other annular connecting regions surrounds at least the inner annular connecting region radially on the outside,
- wherein the annular connecting regions, as seen from inside radially to the outside, form a two- or multiple-stage adhesively bonded meandering structure, **characterized in that**
- the adhesive layer (110) has at least one layer section (310) which, in cross section, is u-shaped or is u-shaped at least in sections and has two side walls (311, 312) and a base wall (313) which connects the two side walls (311, 312),
- each of the two side walls (311, 312) in each case forms an adhesive section which is arranged at an angle to the support plane in which the two housing parts lie one on the other, and
- the base wall (313) of the layer section (310) lies on a base of a recess (101), which base is parallel to the support plane in particular, in one of the two housing parts, in particular on a groove base in the case of a groove-like recess (101).

2. Module (1) according to Claim 1,
**characterized in that**
- the recess (101) is annular and runs around the outside of the interior (2a) of the module housing (2) in an annular manner,
- the protrusion (103), which engages into the recess (101), of the other housing part likewise runs around the outside of the interior (2a) of the module housing (2) in an annular manner and engages as an annular protrusion (103) into the annular recess (101), and
- a layer section (310) of the adhesive layer (110), which layer section lies between the inner wall of the recess (101) and the engaging protrusion (103), forms an annular sealing ring which seals off the interior (2a) of the module housing (2) in an annular manner.

3. Module (1) according to either of the preceding claims, **characterized in that**
the adhesive layer (110) fully embeds electrical contacts of the module (1), which are routed to the outside between the two housing parts which are adhesively bonded to one another, in the region between the two housing parts which are adhesively bonded to one another.

4. Module (1) according to one of the preceding claims, **characterized in that**
the recess (101) is groove-like and forms a groove.

5. Module (1) according to one of the preceding claims, **characterized in that**
- one of the two housing parts forms a cooling panel (21, 25) which carries the electrical component, and the other of the two housing parts is an annular frame element (22, 24), or both housing parts are each annular frame elements (22, 23, 24) .

6. Module (1) according to one of the preceding claims, **characterized in that**
the module housing (2) comprises the following module housing parts:
- a lower cooling panel (21) which carries a lower electrical component, preferably a semiconductor switching element, in particular a semiconductor switching element which has a transistor,
- a lower annular frame element (22) which lies on the lower cooling panel (21),
- a central annular frame element (23) which lies on the lower frame element (22), wherein at least two contact rails (5) for making contact with the lower electrical component are routed out of the module housing (2) between the lower and the central annular frame element,
- an upper annular frame element (24) which lies on the central annular frame element (23), wherein at least two contact rails (5) for making contact with an upper electrical component, preferably a semiconductor switching element, in particular a semiconductor switching element which has a transistor, are routed out of the module housing (2) between the central and the upper annular frame element, and
- an upper cooling panel (25) which rests on the upper annular frame element (24) and carries the upper electrical component,
wherein the two housing parts, which are mentioned in Claims 1 to 5, are adhesively bonded by means of the at least one adhesive layer (110) and are sealed off by the adhesive layer (110) form two of said module housing parts which lie directly one on the other.

7. Module (1) according to one of the preceding claims,
**characterized in that**
the module (1) is a converter module for use in energy transmission technology.

8. Converter, in particular multilevel converter, comprising a large number of electrical modules,
**characterized in that**
at least one of the modules, preferably all of the modules, are modules according to one of preceding Claims 1-7.

## Revendications

1. Module (1) électrique ayant moins un composant électrique logé dans un boîtier (2) du module, dans lequel
- le boîtier (2) du module a au moins deux parties de boîtier, qui mises l'une sur l'autre et seules ou conjointement avec une ou plusieurs autres parties du boîtier (2) du module délimitent l'espace (2a) intérieur du boîtier (2) du module, et
- il y a entre les deux parties du boîtier au moins une couche (110) de colle, qui colle l'une à l'autre les deux parties du boîtier,
- les deux parties du boîtier ont au moins deux zones annulaires de liaison, qui font le tour annulairement de l'espace (2a) intérieure du boîtier (2) du module et qui sont formées chacune d'une cavité (101) dans l'une des deux parties du boîtier et d'une saillie (103) de forme complémentaire dans l'autre partie du boîtier, et
- dans les zones annulaires de liaison, la saillie (103) et la paroi intérieure d'une cavité (101) sont collées chacune au moyen de la couche (110) de colle, dans lequel
- l'une des zones annulaires de liaison forme une zone annulaire de liaison se trouvant à l'intérieur, et
- chacune des autres zones annulaires de liaison entourent à l'extérieur radialement au moins la zone annulaire intérieure de liaison,
- dans lequel les zones annulaires de liaison considérées de l'intérieur vers l'extérieur radialement forment une structure sinueuse collée à deux étages ou à plusieurs étages,
**caractérisé en ce que**
- la couche (110) de colle a au moins une partie (310) de couche, qui en section transversale est en forme de u ou en forme de u au moins par endroit et a deux parois (311, 312) latérales et une paroi (313) de fond reliant les deux parois (311, 312) latérales,
- chacune des deux parois (311, 312) latérales forme respectivement une partie de colle, qui est disposée en faisant un angle avec le plan d'application, dans lequel les deux parties du boîtier sont appliquées l'une sur l'autre, et
- la partie (313) de fond de la partie (310) de couche s'applique à un fond, notamment parallèle au plan d'application, d'une cavité (101) dans l'une des deux parties du boîtier, notamment à un fond rainuré dans le cas d'une cavité (101) en forme de rainure.

2. Module (1) suivant la revendication 1,
**caractérisé en ce que**
- la cavité (101) est annulaire et fait le tour à l'extérieur annulairement autour de l'espace (2a) intérieur du boîtier (2) du module,
- la saillie (103), pénétrant dans la cavité (101), de l'autre partie du boîtier, fait le tour à l'extérieur également annulairement, autour de l'espace (2a) intérieur du boîtier (2) du module et pénètre sous la forme d'une saillie (103) annulaire dans la cavité (101) annulaire et
- une partie (310) de couche, se trouvant entre la paroi intérieure de la cavité (101) et la saillie (103) pénétrante, de la couche (110) de colle forme une bague d'étanchéité annulaire, qui rend étanche annulairement l'espace (2a) intérieur du boîtier (2) du module.

3. Module (1) suivant l'une des revendications précédentes, **caractérisé en ce que**
la couche (110) de colle enrobe complètement, dans la zone comprise entre les deux parties de boîtier du boîtier collées l'une à l'autre, des contacts électriques du module (1), qui sortent vers l'extérieur entre les deux parties du boîtier collées l'une à l'autre.

4. Module (1) suivant l'une des revendications précédentes,
**caractérisé en ce que**
la cavité (101) est en forme de rainure et forme une rainure.

5. Module (1) suivant l'une des revendications précédentes,
**caractérisé en ce que**
- l'une des deux parties du boîtier forme une plaque (21, 25) de refroidissement portant le composant électrique et l'autre des deux parties du boîtier est un élément (22, 24) annulaire de cadre ou
les deux parties du boîtier sont chacune des éléments (22, 23, 24) annulaires de boîtier.

6. Module (1) suivant l'une des revendications précédentes,
**caractérisé en ce que**
le boîtier (2) du module comprend des parties de boîtier du module suivantes :
- une plaque (21) inférieure de refroidissement, qui porte un composant électrique inférieur, de préférence un élément de coupure à semi-conducteur, notamment un élément de coupure à semi-conducteur ayant un transistor,
- un élément (22) annulaire inférieur de cadre, qui s'applique à la plaque (21) inférieure de refroidissement,
- un élément (23) annulaire médian de cadre, qui s'applique à l'élément (22) inférieur de cadre, dans lequel entre l'élément annulaire inférieur de cadre et l'élément annulaire médian de cadre sortent du boîtier (2) du module au moins deux barres (5) de contact pour la mise en contact du composant électrique inférieur,
- un élément (24) annulaire supérieur de cadre, qui s'applique à l'élément (23) annulaire médian de cadre, dans lequel entre l'élément annulaire médian de cadre et l'élément annulaire supérieur de cadre sortent du boîtier (2) du module au moins deux barres (5) de contact pour la mise en contact d'un composant électrique supérieur, de préférence d'un élément de coupure à semi-conducteur, notamment d'un élément de coupure à semi-conducteur ayant un transistor, et
- une plaque (25) supérieure de refroidissement, qui s'applique à l'élément (24) annulaire supérieur de cadre et qui porte le composant électrique supérieur,
dans lequel les deux parties du boîtier mentionnées aux revendications 1 à 5, collées au moyen de la au moins une couche (110) de colle et rendues étanches par la couche (110) de colle, forment deux desdites parties de boîtier du module, qui sont disposées directement l'une sur l'autre.

7. Module (1) suivant l'une des revendications précédentes,
**caractérisé en ce que**
le module (1) est un module de convertisseur à utiliser dans la technique de transport d'énergie.

8. Convertisseur, notamment convertisseur à niveaux multiples comprenant une pluralité de modules électriques,
**caractérisé en ce que**
au moins l'un des modules, de préférence tous les modules, sont des modules suivant l'une des revendications 1 à 7 précédentes.
